# EUROPEAN PATENT APPLICATION

(11) **EP 2 837 520 A2**
(43) Date of publication of application: **18.02.2015**
(21) Application number: 14172808.9
(22) Date of filing: 17.06.2014
(51) Int. Cl.: B60K 37/02

(54) **Vehicle instrument panel with magnet equipped pointer**

(30) Priority: 30.07.2013 US 201313954189
(71) Applicant: Delphi Technologies, Inc., Troy MI 48007 (US)
(72) Inventor: Blackmer, Stephen C., Millington, MI Michigan 48746 (US); Clugston, Mark J., Davison, MI Michigan 48423 (US); Liburdi, Steven A., Grosse Pointe Farms, MI Michigan 48236 (US)
(74) Representative: Robert, Vincent

(57) **Abstract**

A vehicle instrument panel assembly (10) configured to determine an orientation angle (32) of a stepper motor (12) actuated pointer (14, 114) of the assembly (10). The assembly (10) includes a pointer (14, 114), a stepper motor (12), a magnet (24), and a sensor (34). The pointer (14, 114) is movable about an axis (16, 116) to point to indicia on a display surface of the assembly (10). The stepper motor (12) is coupled to the pointer (14, 114) via a reduction gear arrangement (20). The magnet (24) is fixedly coupled to the pointer (14, 114) such that a magnetic field direction (30) generated by the magnet (24) corresponds to an angle (32) of the pointer (14, 114). The sensor (34) is configured to determine the magnetic field direction (30) of the magnet (24) and output a signal indicative of the angle (32) of the pointer (14, 114).

## Description

### TECHNICAL FIELD OF INVENTION

This disclosure generally relates to vehicle instrument panel assembly, and more particularly relates to a pointer equipped with a magnet so a magnetic field sensor can determine the angle of the pointer.

### BACKGROUND OF INVENTION

When vehicle instrument panel assemblies with traditional pointers are manufactured, a camera is used to determine any offset error between the actual pointer location and a desired pointer location corresponding to an indicia or grad on the display. This offset is programmed into the instrument panel to ensure that the offset is applied each time the instrument panel is powered. If power to the instrument panel is interrupted during normal operation, the instrument cluster does a "homing" operation to spin the pointer back to a zero position. As the pointer angle is unknown when power is applied, occasionally the motor will hit an internal hard-stop with enough force that motor drive bounces back out a step or two, and so the gauge becomes inaccurate.

### SUMMARY OF THE INVENTION

In accordance with one embodiment, a vehicle instrument panel assembly configured to determine an orientation angle of a stepper motor actuated pointer of the assembly is provided. The assembly includes a pointer, a stepper motor, a magnet, and a sensor. The pointer is movable about an axis to point to indicia on a display surface of the assembly. The stepper motor is coupled to the pointer via a reduction gear arrangement. The magnet is fixedly coupled to the pointer such that a magnetic field direction generated by the magnet corresponds to an angle of the pointer. The sensor is configured to determine the magnetic field direction of the magnet and output a signal indicative of the angle of the pointer.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is an exploded view of a portion of a vehicle instrument panel assembly in accordance with one embodiment;
Fig. 2 is an exploded view of a motor assembly of Fig. 1 in accordance with one embodiment;
Fig. 3 is a sectional side view of the portion of a vehicle instrument panel assembly of Fig. 1 in accordance with one embodiment; and
Fig. 4 is an exploded view of an alternative embodiment of the portion of a vehicle instrument panel assembly of Fig. 1 in accordance with one embodiment.

### DETAILED DESCRIPTION

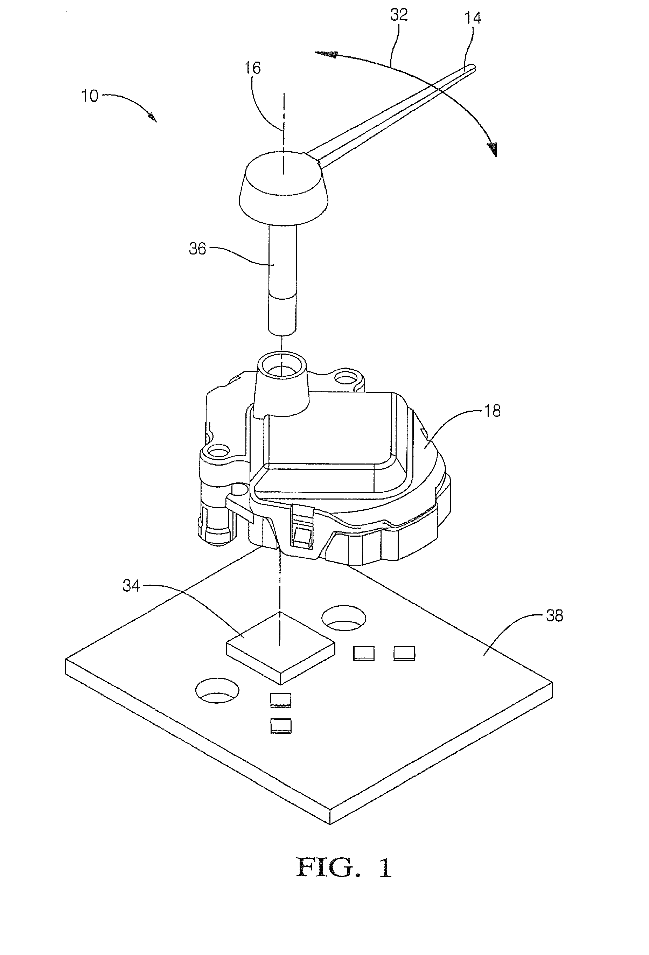

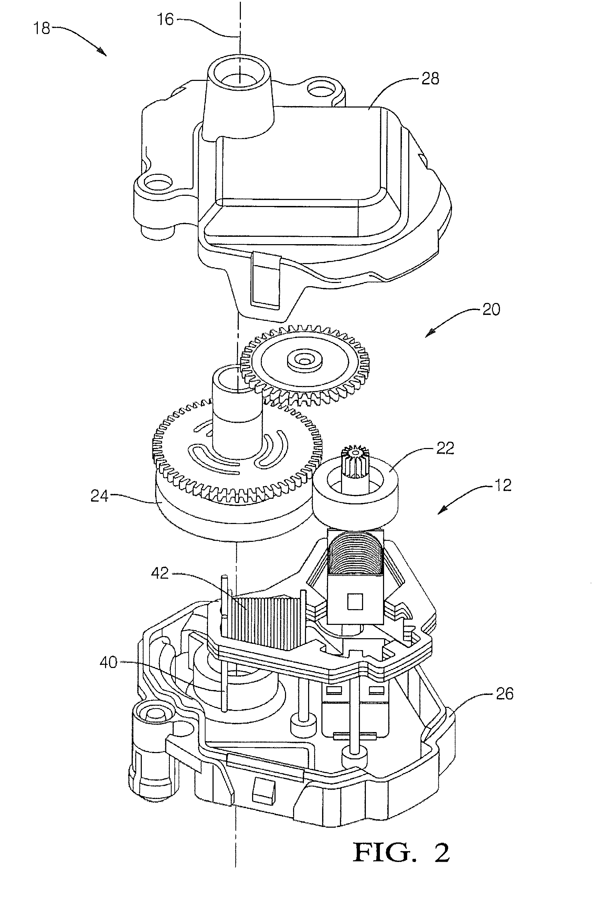

Figs. 1 and 2 illustrate a non-limiting example of part of a vehicle instrument panel assembly, hereafter referred to as the assembly 10, configured to determine an orientation angle of a pointer 14 actuated by a stepper motor 12 (Fig. 2) of the assembly 10. In general, the pointer 14 is movable about an axis to point to indicia on a display surface (not shown) of the assembly 10.

The stepper motor 12 in this example is part of a motor assembly 18 that may include a reduction gear arrangement 20 that couples the stepper motor 12 to the pointer 14 such that a plurality of rotations by a rotor 22 of the stepper motor, one-hundred (100) rotations or revolutions for example, is necessary to move the pointer 14 through a range of motion, two-hundred-forty degrees (240°) of angle for example. As such, the stepper motor 12 is coupled to the pointer 14 via a reduction gear arrangement 20. The motor assembly 18 may also include a housing 26 and a cover 28 that cooperate to keep the various parts (gears, rotor, and stator) that form the stepper motor 12 and the reduction gear arrangement 20 in place.

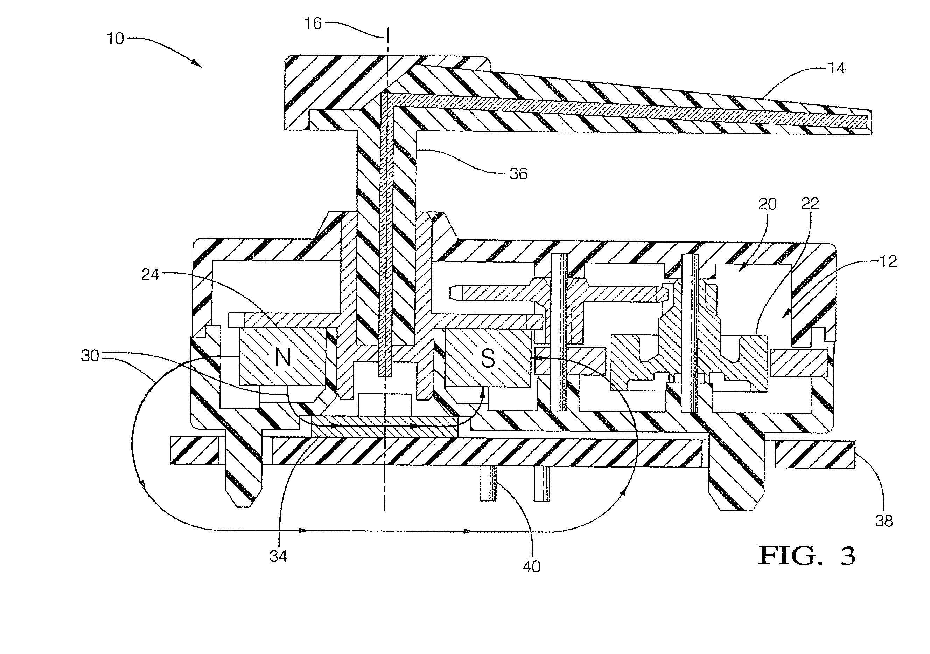

Fig. 3 further illustrates non-limiting details of the assembly 10, which includes a magnet 24 (i.e. a sense magnet, not to be confused with the magnet portion of the rotor 22) fixedly coupled to the pointer 14. As the magnet 24 is fixedly coupled to the pointer 14, a magnetic field direction 30 generated by the magnet 24 corresponds to an angle 32 (Fig. 1) of the pointer 14. Accordingly, the assembly 10 also includes a sensor 34 configured to determine the magnetic field direction 30 of the magnet 24 and output a signal (not shown) indicative of the angle 32 of the pointer 14. By way of example and not limitation, a suitable sensor is the MLX90316 available from Melexis Microelectronic Systems headquartered in Belgium.

The pointer 14 is advantageously mounted on or coupled to a shaft 36 configured to rotate about the axis 16, and the magnet 24 is also attached to the shaft 36. Such a direct coupling as illustrated is advantageous as it reduces the risk of the magnet 24 and pointer 14 shifting or moving relative to each other, which could lead to poor correlation between the angle 32 and the magnetic field direction 30.

In the embodiment shown in Figs. 1-3, the sensor 34 includes a Hall Effect direction sensor (e.g. the MLX90316 described above) located proximate to and coaxial with the magnet 24, i.e. - aligned with the axis 16. In this example, the sensor 34 is surface mount attached to a circuit board 38 using solder for example, as will be recognized by those in the art. The circuit board 38 may also be used to make electrical contact with a coil pin 40 of a coil 42 forming the stator portion of the stepper motor 12.

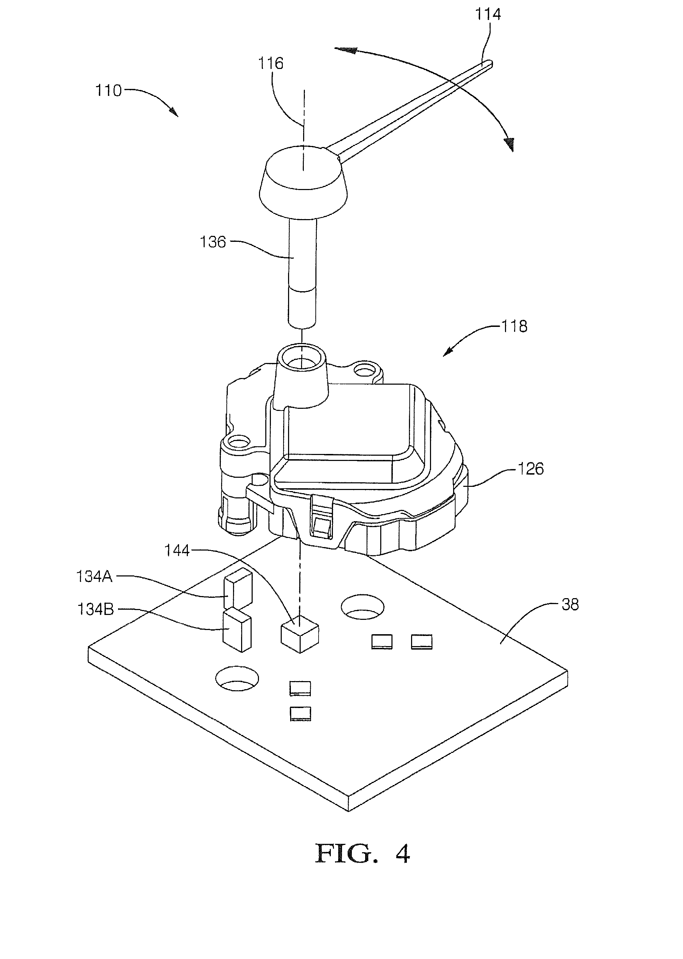

Fig. 4 shows a non-limiting example of an alternative embodiment of the assembly 10, labeled as the assembly 110. It may be preferable to include a light source 144, such as a light emitting diode (LED), at the location where the sensor 34 is shown in Figs. 1 and 3 so that light can be projected up the shaft 136 to illuminate the pointer 114. In this optional embodiment, the sensor 34 may be replaced by two magnetic field strength sensors, e.g. sensors 134A and 134B, located proximate to a periphery of the magnet (not shown, but the same as the magnet 24) located in the motor assembly 118. Those skilled in the art of magnetic field sensing will recognize that the sensors 134A and 134B have an orthogonal orientation relative to the axis 116, and are preferably adjacent to the housing 126. By comparing the field strengths and polarities from the magnet, the sensors 134A and 134B can be used to determine a field direction comparable to the magnetic field direction 30.

Accordingly, a vehicle instrument panel assembly (the assembly 10, the assembly 110) assembly configured to determine an orientation angle of a stepper motor actuated pointer of the assembly is provided. A magnet directly coupled to the pointer generates a magnetic field, which is detected by magnetic field sensors (the sensor 34 or the sensors 134A, 134B). The advantage of this configuration is that if the stepper motor 12 is overcome by an external force such that the rotor 22 moves even though the motive force generated by the stator did not change (i.e. the stepper motor 'skips a step'), the angular position (the angle 32) of the pointer 14, 114 is still known. This provides a solution to a long standing pointer position sensing problem that uses currently available technologies with minimal cost and flexibility in implementation. It is an improvement over prior art solutions that must drive the pointer into a mechanical stop to learn a zero position if power is momentarily lost. It is also an improvement over prior art solutions that have a light detector or the like that can sense the location of the pointer at one location as calibration verification does not need to wait for the pointer to pass over that one location. Since the magnets for the rotor 22 and the magnetic field generated by the coils 42 are not located near the shaft 36, a bi-polar neodymium magnet can be located in the same axis 16 as shaft 36. Clearance is provided by the housing 26 for the sensor 34.

While this invention has been described in terms of the preferred embodiments thereof, it is not intended to be so limited, but rather only to the extent set forth in the claims that follow.

## Claims

1. A vehicle instrument panel assembly (10) configured to determine an orientation angle (32) of a stepper motor actuated pointer (14, 114) of the assembly (10), said assembly (10) comprising:
a pointer (14, 114) movable about an axis (16, 116) to point to indicia on a display surface of the assembly (10);
a stepper motor (12) coupled to the pointer (14, 114);
a magnet (24) fixedly coupled to the pointer (14, 114) such that a magnetic field direction (30) generated by the magnet (24) corresponds to an angle (32) of the pointer (14, 114); and
a sensor (34) configured to determine the magnetic field direction (30) of the magnet (24) and output a signal indicative of the angle (32) of the pointer (14, 114).

2. The assembly (10) in accordance with claim 1, wherein the pointer (14, 114) is mounted on a shaft (36, 136) configured to rotate about the axis (16, 116) and the magnet (24) is attached to the shaft (36, 136).

3. The assembly (10) in accordance with claim 2, wherein the sensor (34) comprises a Hall Effect direction sensor (34) located proximate to and coaxial with the magnet (24).

4. The assembly (10) in accordance with claim 2, wherein the sensor (34) comprises two magnetic field strength sensors (134A, 134B) located proximate to a periphery of the magnet (24).

5. The assembly (10) in accordance with claim 1, wherein the stepper motor (12) is coupled to the pointer (14, 114) via a reduction gear arrangement (20).
